# EUROPÄISCHE PATENTSCHRIFT

(11) **EP 1 177 572 B1**
(45) Veröffentlichungstag und Bekanntmachung des Hinweises auf die Patenterteilung: **12.07.2006**
(21) Anmeldenummer: 00940169.6
(22) Anmeldetag: 05.05.2000
(51) Int. Cl.: H01L 21/00

(54) **ANLAGE ZUR BEARBEITUNG VON WAFERN**
DEVICE FOR TREATING WAFERS
DISPOSITIF DE TRAITEMENT DE PLAQUETTES

(30) Priorität: 07.05.1999 DE 19921243
(43) Veröffentlichungstag der Anmeldung: 06.02.2002
(73) Patentinhaber: Infineon Technologies AG, 81669 München (DE)
(72) Erfinder: GOETZKE, Michael, D-88090 Immenstaad (DE)
(74) Vertreter: Epping - Hermann - Fischer
(86) Internationale Anmeldenummer: PCT/DE2000/001450
(87) Internationale Veröffentlichungsnummer: WO 2000/068971

(56) Entgegenhaltungen:
- WO-A-00/22653
- DE-A- 19 962 703
- DE-C- 19 652 254
- GB-A- 2 210 996
- GB-A- 2 249 868
- US-A- 5 772 387
- US-A- 5 972 727

## Beschreibung

Die Erfindung betrifft eine Anlage zur Bearbeitung von Wafern gemäß dem Oberbegriff des Anspruchs 1.

Derartige Anlagen umfassen eine Vielzahl von Fertigungseinheiten, mit welchen unterschiedliche Fertigungsschritte zur Bearbeitung der Wafer durchgeführt werden. Bei diesen Fertigungsschritten handelt es sich insbesondere um Ätzprozesse, Naßchemieverfahren, Diffusionsprozesse sowie diverse Reinigungsverfahren wie zum Beispiel CMP-Verfahren (Chemical Mechanical Polishing). Für jeden der entsprechenden Fertigungsschritte sind eine oder mehrere Fertigungseinheiten vorgesehen. Zudem sind Meßeinheiten vorgesehen, in welchen die Güte der Bearbeitung der Wafer kontrolliert werden kann. Zweckmä-βigerweise werden mit derartigen Meßeinheiten sämtliche Fertigungsschritte, welche in den Fertigungseinheiten durchgeführt werden, kontrolliert.

Der gesamte Fertigungsprozeß unterliegt strengen Reinheitsanforderungen, so daß die Fertigungseinheiten und Meßeinheiten in einem Reinraum oder in einem System von Reinräumen angeordnet sind.

Die Wafer werden in vorbestimmten Losgrößen über ein Transportsystem den einzelnen Fertigungs- und Meßeinheiten zugeführt. Hierzu werden die Wafer in Transportbehältern, welche beispielsweise in Form von Kassetten ausgebildet sind, transportiert, wobei die Transportbehälter jeweils die gleiche Anzahl von Wafern aufnehmen. Auch der Abtransport nach der Bearbeitung der Wafer in den Fertigungs- und Meßeinheiten erfolgt über das Transportsystem, wobei die Wafer dabei in denselben Transportbehältern gelagert sind.

Das Transportsystem weist ein Fördersystem auf, welches beispielsweise in Form von Rollenförderern ausgebildet ist. Zudem weist das Transportsystem ein Speichersystem mit mehreren Speichern zur Lagerung von Transportbehältern mit Wafern auf. Zweckmäßigerweise sind die Speicher als Stocker ausgebildet. Derartige Stocker sind Speichersysteme, in welchen Wafer unter Reinraumbedingngen gelagert werden.

Bei bekannten Anlagen zur Bearbeitung von Wafern wird ein in einem Transportbehälter zusammengefaßtes Los mit Wafern über das Transportsystem durch sämtliche Fertigungs- und Meßeinheiten der Anlage geführt. Dabei verbleibt die Bindung des Loses an den jeweiligen Transportbehälter. Dies bedeutet, daß Wafer von verschiedenen Losen nicht durchmischt werden.

Dabei wird zur Bearbeitung der Wafer jeweils ein Transportbehälter mit einem Los einer Fertigungseinheit über eine Beund Entladestation zugeführt. Nach Bearbeitung der Wafer in der Fertigungseinheit wird das Los in denselben Transportbehälter wieder über die Be- und Entladestation an das Transportsystem ausgegeben.

Zur Kontrolle des in der Fertigungseinheit durchgeführten Fertigungsschrittes wird danach der Transportbehälter einer entsprechenden Meßeinheit zugeführt, welche ebenfalls eine Be- und Entladestation aufweist.

In der Meßeinheit wird geprüft, ob die einzelnen Wafer des Loses korrekt bearbeitet wurden. Dabei erfolgt üblicherweise eine Klassifizierung in fehlerfreie Wafer, Ausschuß-Wafer, welche nicht behebbare Mängel aufweisen sowie nachzuarbeitende Wafer, welche durch Nachbearbeitungen wieder die geforderte Qualität erfüllen.

Die nicht mehr verwendbaren Ausschuß-Wafer werden aus dem Produktionsprozeß ausgegliedert, während die nachzuarbeitenden Wafer und die fehlerfreien Wafer wieder in den Transportbehälter gefüllt und über die Entladestation ausgegeben wer den. Da einige Wafer dieses Loses als Ausschuss aussortiert werden, verbleiben Lücken im Transportbehälter.

Nachteilig hierbei ist, dass bei derartigen Anlagen nur teilweise mit Wafern befüllte Transportbehälter im Umlauf sind. Dies bedeutet nicht nur eine mangelhafte Auslastung der Transportkapazitäten. Vielmehr ist damit auch eine große Durchlaufzeit der Wafer durch die Anlage verbunden. Dabei ist insbesondere nachteilig, dass bei nachfolgenden Fertigungsprozessen, bei welchen mehrere Lose zusammengefasst werden, keine optimale Auslastung erzielt wird. Hierzu gehören insbesondere Oxidationsprozesse, welche in Öfen durchgeführt werden. Bei diesen Prozessen werden, um Lücken in einem Transportlos zu vermeiden diese mit sogenannten Dummy-Wafern befüllt, bis die Anzahl der Wafer der ursprünglichen Losgröße entspricht. Derartige Dummy-Wafer haben außer der Platzhalterfunktion im Transportlos, welche eine homogene Temperaturverteilung innerhalb des Ofens gewährleistet, keine weitere Funktion und sind insbesondere für den weiteren Fertigungsprozess in der Anlage unbrauchbar.

Dies macht eine Zwischenlagerung derartiger Transportbehälter in separaten Speichersystemen notwendig, um sie später zu einem geeigneten Zeitpunkt Fertigungseinheiten zuzuführen, in welchen die Nachbearbeitung der nachzuarbeitenden Wafer erfolgen kann. Die ebenfalls im Transportbehälter angeordneten fehlerfreien Wafer werden dabei im Los des Transportbehälters mitgeführt. Dies bedeutet erhebliche Wartezeiten für die fehlerfreien Wafer.

Aus der DE 37 35 449 A1 ist ein Fertigungssystem für Wafer bekannt, welches aus mehreren austauschbaren Transportmodulen, Prozessmodulen und Kontrollmodulen zusammengesetzt ist. Jedes Prozessmodul weist jeweils wenigstens eine Prozessstation, eine Ablage und ein Handhabungsgerät auf.

Die Wafer werden in einer ersten Kassette über das Transportmodul angeliefert. Das Handhabungsgerät entnimmt die Wafer aus der ersten Kassette und führt sie den Prozessstationen und Ablagen zu. Im Kontrollmodul werden unbrauchbare Wafer erfasst und gegebenenfalls in einer zweiten Kassette gesammelt. Die zweite Kassette kann zur Zwischenlagerung der unbrauchbaren Wafer dienen. Alternativ werden die unbrauchbaren Wafer aus dem Kontrollmodul ausgeschleust. Die fehlerfreien Wafer werden in Kassetten gesammelt und wieder auf dem Transportmodul ausgegeben.

Die DE 195 14 037 A1 betrifft eine Transportvorrichtung zur Beförderung von Substraten. Die Transportvorrichtung ist als Drehtisch ausgebildet, der in einer gleichbleibenden Taktfrequenz angetrieben wird. Das Substrat kann mittels eines drehbar gelagerten Substratgreifers einer außerhalb des Drehtisches vorgesehenen Prozessstation zugeführt werden.

Aus der DE 195 23 969 A1 ist ein IC-Transportsystem bekannt, welches in Verbindung mit einem tablettartigen Magazin oder einem stabförmigen Magazin betrieben werden kann. Durch ein Verfahren zum wiederholten Testen von Bausteinen in einer IC-Prüfungshandhabungseinrichtung werden im Magazin gespeicherte Bausteine ohne das Eingreifen durch eine Bedienungsperson wiederholt geprüft und die Bausteine gemäß den Testergebnissen sortiert und im Magazin gespeichert.

Die JP 08268512 A betrifft eine Speichereinheit zur Speicherung von Substraten. Die Speichereinheit umfasst eine Sortiereinheit, mittels derer die Substrate selbsttätig sortiert und in Kassetten in der Speichereinheit eingelagert oder ausgelagert werden.

Der Erfindung liegt die Aufgabe zugrunde eine Anlage der eingangs genannten Art so auszubilden, dass ein möglichst effizienter Materialfluss der Wafer durch die Anlage gewährleistet ist.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Erfindungsgemäß sind in der Anlage zur Bearbeitung von Wafern Messstationen vorgesehen, welche jeweils eine oder mehrere Messeinheiten sowie wenigstens eine Entladestation zur Ausgabe der Wafer an das Transportsystem aufweisen.

In der Messstation werden erste Transportbehälter mit fehlerfreien Wafern befüllt, welche die Kontrolle in der oder in den Messeinheiten der Messstation erfolgreich durchlaufen haben. Die übrigen, nicht fehlerfreien Wafer werden in andere, zweite Transportbehälter gefüllt. Zweckmäßigerweise werden dabei nachzuarbeitende Wafer in zweite Transportbehälter gefüllt. Dritte Transportbehälter werden schließlich mit Ausschuss-Wafern befüllt, welche nicht mehr nacharbeitbar sind.

Über die Entladestation der Messstation werden die unterschiedlichen Transportbehälter separat voneinander an das Transportsystem ausgegeben. Dabei sind die ersten, zweiten und gegebenenfalls dritten Transportbehälter unterschiedlich, vorzugsweise in unterschiedlichen Farben gekennzeichnet und werden über verschiedene Entladeports der Entladestation, welche vorzugsweise in entsprechender Weise gekennzeichnet sind, ausgegeben.

Der wesentliche Vorteil der erfindungsgemäßen Anlage besteht darin, dass über die Messstation erste Transportbehälter ausgegeben werden, welche komplett mit fehlerfreien Wafern befüllt sind. Nur diese Wafer bleiben im Fertigungsprozess in der Anlage, so dass ein optimaler Auslastungsgrad der Transportbehälter erzielt wird, was auch zu einer erheblichen Verkürzung der Durchlaufzeit der Wafer durch die Anlage führt. Die Ausschuss-Wafer können am Ausgang der Messstation komplett aus dem Fertigungsprozess ausgeschleust werden. Die mit nachzuarbeitenden Wafern befüllten zweiten Transportbehälter werden, gegebenenfalls nach einer Zwischenlagerung, Fertigungseinheiten zur Durchführung der Nacharbeitungsprozesse zugeführt. Besonders vorteilhaft dabei ist, daß diese zweiten Transportbehälter keine fehlerfreien Wafer mehr enthalten, so daß für die fehlerfreien Wafer keine unnötige Wartezeiten entstehen. Auch die Nacharbeitungsprozesse selbst werden dadurch effizienter, da den entsprechenden Fertigungseinheiten nur noch zweite Transportbehälter zugeführt werden, in welchen sich allein nachzuarbeitende Wafer befinden. Entsprechende Sortiervorgänge entfallen somit.

Schließlich ist vorteilhaft, daß durch die unterschiedliche Kennzeichnung der ersten, zweiten und dritten Transportbehälter eine fehlersichere und einfache Zuordnung der unterschiedlichen Transportbehälter zu den jeweiligen Fertigungs- und Meßeinheiten ermöglicht wird.

Die Erfindung wird im nachstehenden anhand der Zeichnungen erläutert. Es zeigen:
- Figur 1:: Schematische Darstellung einer Anlage zur Bearbeitung von Wafern mit mehreren Fertigungseinheiten und Meßstationen.
- Figur 2:: Schematische Darstellung einer Meßstation gemäß Figur 1.

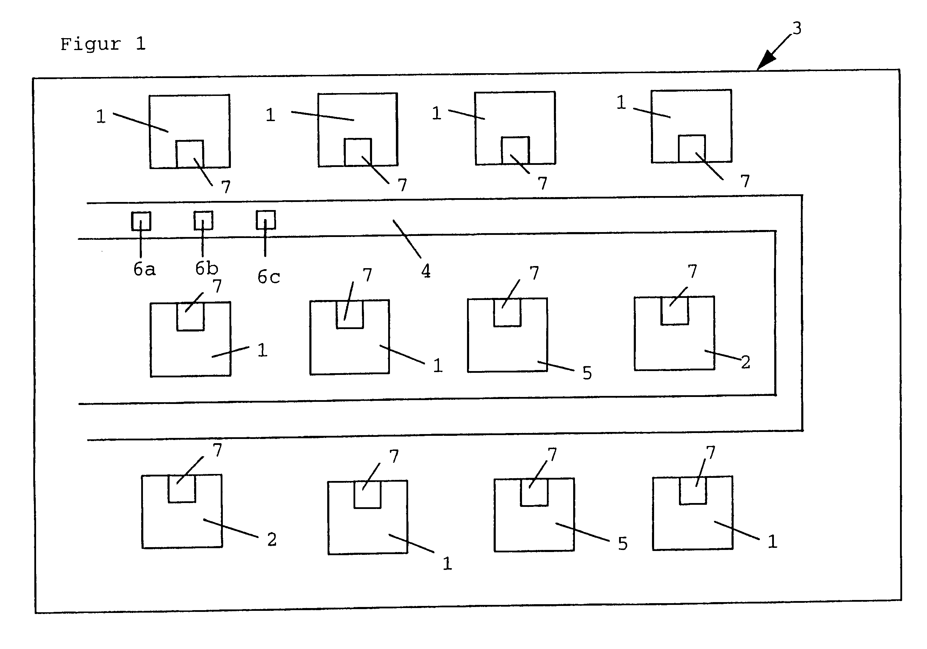

Figur 1 zeigt ein Ausführungsbeispiel einer Anlage zur Bearbeitung von Wafern. Die Anlage umfaßt eine Vielzahl von Fertigungseinheiten 1 zur Durchführung von für die Bearbeitung der Wafer notwendigen Fertigungsschritten. Derartige Fertigungsschritte umfassen Bearbeitungsvorgänge bei Ätzprozessen, Naßchemieverfahren, Diffusionsprozessen sowie Reinigungsverfahren. Für diese Fertigungsschritte können jeweils eine oder mehrere Fertigungseinheiten 1 vorgesehen sein.

Zudem umfaßt die Anlage eine Vielzahl von Meßstationen 2, in welchen die Resultate der einzelnen Fertigungsschritte überprüft werden.

Die Fertigungseinheiten 1 und die Meßstationen 2 sind in einem Reinraum 3 angeordnet Alternativ kann die Anlage über ein System von Reinräumen 3 verteilt sein.

Die Fertigungseinheiten 1 und die Meßstationen 2 sind über ein Transportsystem miteinander verbunden. Das Transportsystem weist ein Fördersystem 4 und ein Speichersystem auf. Das Fördersystem 4 kann beispielsweise von einem System von Rollenförderern 12 gebildet sein. Die Speicher 5 des Speichersystems sind vorzugsweise als Stocker ausgebildet.

Über das Fördersystem 4 werden die Wafer in Transportbehältern 6a, 6b, 6c transportiert. Die Transportbehälter 6a, 6b, 6c können in Form von Kassetten oder dergleichen ausgebildet sein.

Die Fertigungseinheiten 1, die Meßstationen 2 sowie die Speicher 5 weisen für die Zufuhr und den Abtransport jeweils wenigstens eine Be- und Entladestation 7 auf.

Zweckmäßigerweise werden den einzelnen Fertigungseinheiten 1 Wafer in bestimmten Losgrößen in jeweils einem Transportbehälter 6a zugeführt. Nach der Bearbeitung der Wafer in der Fertigungseinheit 1 werden die Wafer in demselben Transportbehälter 6a an das Transportsystem ausgegeben und über dieses einer Meßstation 2 zur Überprüfung der Qualität der Bearbeitung in der Fertigungseinheit 1 zugeführt.

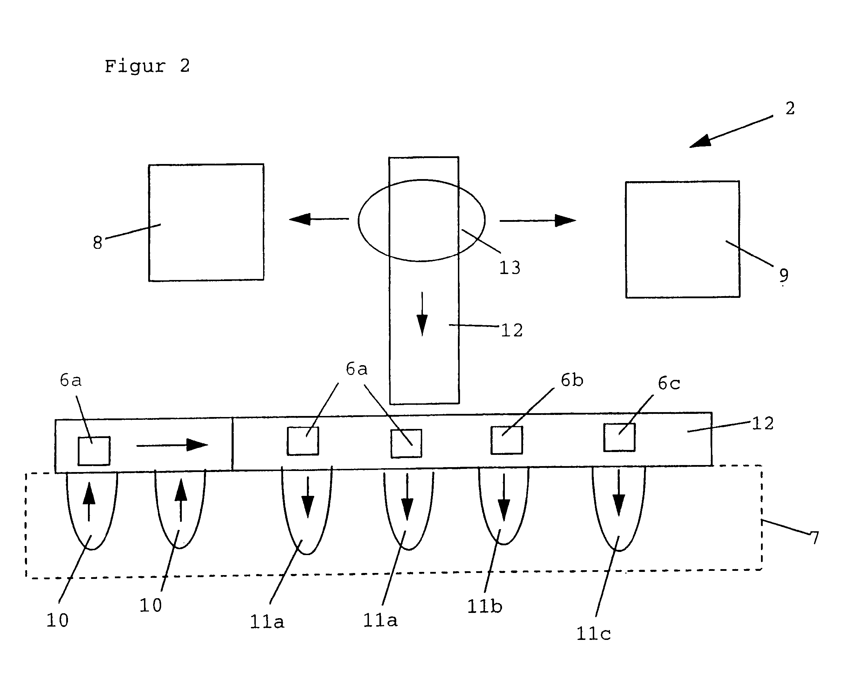

Der Aufbau einer derartigen Meßstation 2 ist in Figur 2 beispielhaft dargestellt. Die Meßstation 2 weist zwei Meßeinheiten 8, 9 auf, in welchen unterschiedliche Kontrollfunktionen realisiert werden können. Beispielsweise kann die Meßstation 2 zur Kontrolle von Fertigungsschritten eines in mehreren Fertigungseinheiten 1 durchgeführten Lithographie-Prozesses vorgesehen sein. Die eine Meßeinheit 8 kann dann typischerweise als Kontrollsystem ausgebildet sein, welches abprüft, ob Mehrfachstrukturen, welche Wafer im Inneren aufweisen, korrekt übereinanderliegend angeordnet sind. Die zweite Meßeinheit 9 kann als optische Kontrollvorrichtung zum Erkennen von Verwerfungen auf den Wafern ausgebildet sein.

Die Meßstation 2 weist eine Be- und Entladestation 7 auf, über welche Transportbehälter 6a, 6b, 6c mit Wafern angeliefert und von der Meßstation 2 an das Transportsystem ausgegeben werden. Die Be- und Entladestation 7 besteht aus einer Beladestation und einer Entladestation, welche räumlich getrennt voneinander angeordnet sind. Im vorliegenden Ausführungsbeispiel sind als Beladestation zwei Beladeports 10 vorgesehen. Die Entladestation weist mehrere Entladeports 11a, 11b, 11c auf. Von den Beladeports 10 und den Entladeports 11a, 11b, 11c führen Rollenförderer 12 zu den Meßeinheiten 8, 9. An den Rollenförderern 12 ist im Bereich der Meßeinheiten 8, 9 ein Handhabungsgerät 13 angeordnet, welches von einem Roboter oder dergleichen gebildet sein kann. Zweckmäßigerweise werden die Wafer unmittelbar nach Eingang in die Meßstation 2 vereinzelt. Dies kann durch das Bedienpersonal oder mittels nicht dargestellter Greifer erfolgen. Dabei werden die einzelnen Wafer aus den Transportbehältern 6a entnommen und über die Rollenförderer 12 den Meßeinheiten 8, 9 zugeführt. Über das Handhabungsgerät 13 werden die Wafer einzeln den Me-βeinheiten 8, 9 zugeführt und einzeln aus den Meßeinheiten 8, 9 entnommen. Somit erfolgt in der gesamten Meßstation 2 eine Einzelwaferbearbeitung losgelöst von den durch die Kapazitäten der Transportbehälter 6a, 6b, 6c vorgegebenen Losgrößen.

Damit eine Identifizierung der einzelnen Wafer gewährleistet ist, ist auf jedem Wafer eine Markierung angebracht, welche mittels nicht dargestellter Erfassungssysteme lesbar ist. Beispielsweise können auf den Wafern an Stellen, welche am Schluß des Fertigungsprozesses von der Nutzfläche der Wafer als Abfall abgetrennt werden, Barcodes aufgebracht sein, die Erfassungssysteme sind dann von Barcodelesegeräten gebildet.

Erfindungsgemäß werden die einzelnen Wafer nach der Überprüfung in den Meßeinheiten 8, 9 entsprechend der jeweiligen Bearbeitungsqualität in unterschiedliche Transportbehälter 6a, 6b, 6c gefüllt. Diese Befüllung kann durch das Handhabungsgerät 13 erfolgen. Alternativ kann diese Befüllung durch das Bedienpersonal oder mittels nicht dargestellter Greifer am Ausgang der Meßstation 2 erfolgen. Fehlerfreie Wafer, welche die Kontrolle in den Meßeinheiten 8, 9 erfolgreich durchlaufen haben, werden in erste Transportbehälter 6a gefüllt. Nachzuarbeitende Wafer, welche geringe Mängel aufweisen, die durch geeignete Nachbearbeitungsprozesse behebbar sind, werden in zweite Transportbehälter 6b gefüllt. Schließlich werden Ausschuß-Wafer, welche gravierende, nicht mehr behebbare Mängel aufweisen, in dritte Transportbehälter 6c gefüllt.

Bei der Meßstation 2 gemäß Figur 2 handelt es sich um Meßeinheiten 8, 9 zur Kontrolle von Lithographie-Prozessen. Bei diesen Prozessen fallen üblicherweise nachzuarbeitende Wafer an. Bei anderen Fertigungsprozessen, wie zum Beispiel Oxidationsprozessen fallen üblicherweise nur fehlerfreie Wafer oder Ausschuß-Wafer an, da im Falle einer fehlerhaften Bearbeitung die Mängel an den Wafern derart gravierend sind, daß eine Nacharbeit nicht mehr möglich ist. In diesem Fall werden in der Meßstation 2 nur zwei Sorten von Transportbehältern 6a, 6c benötigt.

Bei dem Ausführungsbeispiel gemäß Figur 2 werden die ersten, zweiten und dritten Transportbehälter 6a, 6b ,6c getrennt über unterschiedliche Entladeports 11a, 11b, 11c aus der Meßstation 2 ausgegeben.

Um Verwechslungen zu vermeiden sind die ersten, zweiten und dritten Transportbehälter 6a, 6b, 6c unterschiedlich gekennzeichnet. Die ersten Transportbehälter 6a, mit den fehlerfreien Wafern sind mit grüner Farbe gekennzeichnet. Die zweiten Transportbehälter 6b mit den nachzuarbeitenden Wafern sind mit gelber Farbe gekennzeichnet. Schließlich sind die dritten Transportbehälter 6c mit den Ausschuß-Wafern mit roter Farbe gekennzeichnet,

Die Entladeports 11a, 11b, 11c, über welche die unterschiedlichen Transportbehälter 6a, 6b, 6c ausgegeben werden, sind in den entsprechenden Farben gekennzeichnet. Im vorliegenden Ausführungsbeispiel sind zwei mit grüner Farbe gekennzeichnete Entladeports 11a zur Ausgabe der grün gekennzeichneten ersten Transportbehälter 6a vorgesehen. Zudem ist jeweils ein gelb und rot gekennzeichneter Entladeport 11b, 11c zur Ausgabe der gelb und rot gekennzeichneten Transportbehälter 6b, 6c vorgesehen.

Die grün gekennzeichneten Transportbehälter 6a sind komplett mit fehlerfreien Wafern befüllt und werden nach Ausgabe aus der Meßstation 2 den weiteren Fertigungseinheiten 1 und Meßstationen 2 zur Bearbeitung zugeführt.

Vorteilhafterweise sind damit nur fehlerfreie Wafer in den mit grüner Farbe gekennzeichneten Transportbehältern 6a in der Anlage zur Bearbeitung im Umlauf.

In einer weiteren vorteilhaften Ausführungsform der Erfindung werden in der Meßstation nicht sämtliche Wafer geprüft. Vielmehr findet nur eine Prüfung eines vorgegebenen Teils des Wafer statt. In diesem Fall ist nur ein Teil der Wafer in den grünen Transportbehältern auf Fehlerfreiheit geprüft.

Die Ausschuß-Wafer in den rot gekennzeichneten Transportbehältern 6c werden zweckmäßigerweise am Ausgang der jeweiligen Meßstation 2 sofort aussortiert. Dieser Prozeß kann vorteilhafterweise manuell erfolgen.

Die nachzuarbeitenden Wafer in den gelb gekennzeichneten Transportbehältern 6b werden zweckmäßigerweise in Speichern 5 zwischengespeichert um dann zu geeigneten Zeitpunkten Fertigungseinheiten 1 zur Nacharbeitung zugeführt zu werden.

Diese Auslagerungs- und Zuführungsprozesse können insbesondere manuell erfolgen, wodurch die nachzuarbeitenden Wafer vom Umlauf der fehlerfreien Wafer auf dem Fördersystem 4 getrennt sind.

## Patentansprüche

1. Anlage zur Bearbeitung von Wafern in wenigstens einem Reinraum mit einer Anordnung von Fertigungseinheiten zur Durchführung einzelner Fertigungsschritte und Meßeinheiten zur Kontrolle der Fertigungsschritte welche zur Zufuhr und zum Abtransport der Wafer über ein Transportsystem verbunden sind,
**dadurch gekennzeichnet,**
**daß** wenigstens eine Meßeinheit (8) mit einer Entladestation zur Ausgabe von Wafern an das Transportsystem eine Meßstation (2) bildet,
wobei in der Meßstation (2) erste Transportbehälter (6a) mit fehlerfreien Wafern befüllt werden, zweite Transportbehälter (6b) mit nachzuarbeitenden Wafern befüllt werden und dritte Transportbehälter (6c) mit Ausschußwafern befüllt werden,
**daß** die ersten, zweiten und dritten Transportbehälter (6a-6c) unterschiedlich **gekennzeichnet** sind,
**daß** die ersten, zweiten und dritten Transportbehälter (6a-6c) getrennt voneinander über die Entladestation aus der Meßstation ausführbar sind, und
**daß** die mit nachzuarbeitenden Wafern befüllten zweiten Transportbehälter (6b) Fertigungseinheiten (1) zur Durchführung von Nacharbeitungsprozessen zuführbar sind.

2. Anlage nach Anspruch 1, **dadurch gekennzeichnet, daß** die ersten, zweiten und dritten Transportbehälter (6a, 6b, 6c) über separate Entladeports (11a, 11b, 11c) der Entladestation ausführbar sind.

3. Anlage nach einem der Ansprüche 1 - 2, **dadurch gekennzeichnet, daß** die ersten, zweiten und dritten Transportbehälter (6a, 6b, 6c) mit unterschiedlichen Farben **gekennzeichnet** sind.

4. Anlage nach Anspruch 3, **dadurch gekennzeichnet, daß** die ersten Transportbehälter (6a) mit grüner Farbe, die zweiten Transportbehälter (6b) mit gelber Farbe und die dritten Transportbehälter (6c) mit roter Farbe **gekennzeichnet** sind.

5. Anlage nach einem der Ansprüche 3 oder 4, **dadurch gekennzeichnet, daß** die Entladeports (11a, 11b, 11c) mit den Farben der diesen Entladeports (11a, 11b, 11c) zugeordneten Transportbehältern (6a, 6b, 6c) **gekennzeichnet** sind.

6. Anlage nach einem der Ansprüche 1 - 5, **dadurch gekennzeichnet, daß** diese ein Speichersystem zur Zwischenlagerung der zweiten und / oder dritten Transportbehälter (6b, 6c) aufweist.

7. Anlage nach Anspruch 6, **dadurch gekennzeichnet, daß** die zweiten und dritten Transportbehälter (6b, 6c) in separaten Speichern (5) des Speichersystems zwischengelagert sind.

8. Anlage nach einem der Ansprüche 6 oder 7, **dadurch gekennzeichnet, daß** die nachzuarbeitenden Wafer in den zweiten Transportbehältern (6b) und / oder die Ausschuß-Wafer in den dritten Transportbehältern (6c) an den Entladeports (11b, 11c) der Entladestationen manuell ausgelagert werden.

9. Anlage nach einem der Ansprüche 1 - 8, **dadurch gekennzeichnet, daß** die Wafer Markierungen zu deren Identifikation aufweisen.

10. Anlage nach Anspruch 9, **dadurch gekennzeichnet, daß** in vorgegebenen Losgrößen an eine Meßstation (2) angelieferte Wafer in der Meßstation (2) vereinzelt werden.

11. Anlage nach Anspruch 10, **dadurch gekennzeichnet, daß** in einer mehrere Meßeinheiten (8, 9) aufweisenden Meßstation (2) die Wafer einzeln bearbeitet werden.

## Claims

1. Installation for processing wafers in at least one clean room, having an arrangement of production units for carrying out individual production steps and measuring units for inspecting the production steps, the production units and measuring units being connected via a transport system for feeding and removing the wafers, **characterized in that** at least one measuring unit (8) together with an unloading station for delivering wafers to the transport system forms a measuring station (2), in which case, in the measuring station (2), first transport containers (6a) are filled with defect-free wafers, second transport containers (6b) are filled with wafers to be reworked and third transport containers (6c) are filled with rejected wafers, **in that** the first, second and third transport containers (6a-6c) are marked differently, **in that** the first, second and third transport containers (6a-6c) can be delivered from the measuring station separately from one another via the unloading station, and **in that** the second transport containers (6b) filled with wafers to be reworked can be fed to production units (1) for carrying out reworking processes.

2. Installation according to Claim 1, **characterized in that** the first, second and third transport containers (6a, 6b, 6c) can be delivered via separate unloading ports (11a, 11b, 11c) of the unloading station.

3. Installation according to either of Claims 1 and 2, **characterized in that** the first, second and third transport containers (6a, 6b, 6c) are marked with different colours.

4. Installation according to Claim 3, **characterized in that** the first transport containers (6a) are marked with a green colour, the second transport containers (6b) are marked with a yellow colour, and the third transport containers (6c) are marked with a red colour.

5. Installation according to either of Claims 3 and 4, **characterized in that** the unloading ports (11a, 11b, 11c) are marked with the colours of the transport containers (6a, 6b, 6c) assigned to these unloading ports (11a, 11b, 11c).

6. Installation according to one of Claims 1 to 5, **characterized in that** it has a storage system for temporarily storing the second and/or third transport containers (6b, 6c).

7. Installation according to Claim 6, **characterized in that** the second and third transport containers (6b, 6c) are temporarily stored in separate storage devices (5) of the storage system.

8. Installation according to either of Claims 6 and 7, **characterized in that** the wafers to be reworked in the second transport containers (6b) and/or the rejected wafers in the third transport containers (6c) are removed from storage manually at the unloading ports (11b, 11c) of the unloading stations.

9. Installation according to one of Claims 1 to 8, **characterized in that** the wafers have markings for identifying them.

10. Installation according to Claim 9, **characterized in that** wafers supplied in predetermined batch sizes to a measuring station (2) are singularized in the measuring station (2).

11. Installation according to Claim 10, **characterized in that** the wafers are processed individually in a measuring station (2) having a plurality of measuring units (8, 9).

## Revendications

1. Installation de traitement de tranches dans au moins une salle blanche, comprenant un agencement d'unités de fabrication pour effectuer des stades de fabrication individuels et des unités de mesure pour contrôler les stades de fabrication, qui sont liées à l'apport et à l'évacuation des tranches sur un système de transport,
**caractérisé,**
**en ce qu'**au moins une unité (8) de mesure forme, avec un poste de déchargement pour décharger des tranches sur le système de transport, un poste (2) de mesure,
dans lequel dans le poste (2) de mesure des premiers récipients (6a) de transport sont emplis de tranches sans défaut, des deuxièmes récipients (6b) de transport sont emplis de tranches à retraiter et des troisièmes récipients (6b) de transport sont emplis de tranches à rebuter,
**en ce que** les premiers, deuxièmes et troisièmes récipients (6a à 6c) de transport sont **caractérisés** de manière différente,
**en ce que** les premiers, deuxièmes et troisièmes récipients (6a à 6c) de transport peuvent être sortis du poste de mesure de façon séparés les uns des autres par le poste de déchargement, et
**en ce que** les deuxièmes récipients (6b) de transport remplis de tranches à retraiter peuvent être envoyés à des unités (1) de fabrication pour effectuer des opérations de retraitement.

2. Installation suivant la revendication 1, **caractérisée en ce que** les premiers, deuxièmes et troisièmes récipients (6a, 6b, 6c) de transport peuvent être sortis par des orifices (11a, 11b, 11c) de déchargement distincts du poste de déchargement.

3. Installation suivant l'une des revendications 1 et 2, **caractérisée en ce que** les premiers, deuxièmes et troisièmes récipients (6a, 6b, 6c) de transport sont **caractérisés par** des couleurs différentes.

4. Installation suivant la revendication 3, **caractérisée en ce que** les premiers récipients (6a) de transport sont **caractérisés par** une couleur verte, les deuxièmes récipients (6b) de transport par une couleur jaune et les troisièmes récipients (6c) de transport par une couleur rouge.

5. Installation suivant l'une des revendications 3 ou 4, **caractérisée en ce que** les orifices (11a, 11b, 11c) de déchargement sont **caractérisés par** les couleurs des récipients (6a, 6b, 6c) de transport, associées à ces orifices (11a, 11b, 11c) de déchargement.

6. Installation suivant l'une des revendications 1 à 5, **caractérisée en ce qu'**elle a un système d'emmagasinage pour l'emmagasinage intermédiaire des deuxièmes et/ou troisièmes récipients (6b) de transport.

7. Installation suivant la revendication 6, **caractérisée en ce que** les troisièmes récipients (6b) de transport sont emmagasinés intermédiairement dans des magasins (5) distincts du système d'emmagasinage.

8. Installation suivant l'une des revendications 6 ou 7, **caractérisée en ce que** les tranches à retraiter dans les deuxièmes récipients (6b) de transport et/ou les tranches à rebuter dans les troisièmes récipients (6c) de transport sont sortis manuellement sur les orifices (11b, 11c) de déchargement des postes de déchargement.

9. Installation suivant l'une des revendications 1 à 8 **caractérisée en ce que** les tranches ont des repérages pour leur identification.

10. Installation suivant la revendication 9, **caractérisée en ce que** des tranches, livrées en grandeur de lot prescrite, à un poste (2) de mesure sont individualisées dans le poste (2) de mesure.

11. Installation suivant la revendication 10, **caractérisée en ce que** les tranches sont traitées individuellement dans un poste (2) de mesure ayant plusieurs unités (8, 9) de mesure.
